# EUROPEAN PATENT SPECIFICATION

(11) **EP 0 285 106 B1**
(45) Date of publication and mention of the grant of the patent: **31.08.1994**
(21) Application number: 88105111.4
(22) Date of filing: 29.03.1988
(51) Int. Cl.: H01L 39/24

(54) **Method of forming superconducting circuit**
Verfahren zur Herstellung einer supraleitenden Schaltung
Méthode de fabrication d'un circuit supraconducteur

(30) Priority: 30.03.1987 JP 79361/87; 14.04.1987 JP 91123/87; 22.08.1987 JP 208881/87
(43) Date of publication of application: 05.10.1988
(73) Proprietor: SUMITOMO ELECTRIC INDUSTRIES LIMITED, Osaka-shi, Osaka 541 (JP)
(72) Inventor: Takahashi, Kenichi c/o Osaka Works, Konohana-ku Osaka-shi Osaka (JP); Yoshida, Noriyuki c/o Osaka Works, Konohana-ku Osaka-shi Osaka (JP); Shioya, Jun c/o Osaka Works, Konohana-ku Osaka-shi Osaka (JP); Yamaguchi, Yoichi c/o Osaka Works, Konohana-ku Osaka-shi Osaka (JP); Mizoguchi, Akira c/o Osaka Works, Konohana-ku Osaka-shi Osaka (JP); Hayashi, Noriki c/o Osaka Works, Konohana-ku Osaka-shi Osaka (JP); Takano, Satoshi c/o Osaka Works, Konohana-ku Osaka-shi Osaka (JP); Miyazaki, Kenji c/o Osaka Works, Konohana-ku Osaka-shi Osaka (JP)
(74) Representative: KUHNEN, WACKER & PARTNER

(56) References cited:
- EP-A- 0 202 895
- EP-A- 0 282 360
- EP-A- 0 286 106
- APPLIED PHYSICS LETTERS, vol. 48, no. 9, 3rd March 1986, pages 601-603, American Institute of Physics; H. KUMAKURA et al.: "Synthesis of Nb3Ga and Nb3Al superconducting composites by laser beam irradiation"
- JAPANESE JOURNAL OF APPLIED PHYSICS/PART 2: LETTERS, vol. 27, no. 2, February 1988, pages L231-L233, Tokyo, JP; N. AIZAKI et al.: "YBa2Cu3Oy superconducting thin film obtained by laser annealing"

## Description

The present invention relates to a method of forming a superconducting circuit, and more particularly, it relates to a method of forming a superconducting circuit on a superconductive ceramics material.

### Description of the Related Art

A superconductive ceramics material is prepared by mixing raw powder materials of oxides, compression-molding the mixture into a prescribed configuration of a block, a sheet or the like and sintering the same, for example. However, it has been difficult to form a fine superconducting circuit by such a method of utilizing compression molding.

In another conventional method of forming a superconducting circuit, a substrate is masked to form a superconducting thin film only on a prescribed portion, thereby to implement a circuit. Alternatively, ion sputtering is performed on a superconducting thin film formed on a substrate to partially scrape off the thin film, thereby to form a circuit.

In addition, document EP-A-0 282 360, a document under Art. 54(3) EPC, relates to a method of forming superconducting circuit elements, such as coils by sputtering onto a substrate surface a layer of a ceramic superconductor material and subsequently selectively irradiating the layer with a laser beam so as to define irradiated and non-irradiated regions.

Furthermore, document EP-A 0 286 106, a further document under Art. 54(3) EPC, discloses a process for controlling an oxygen content of a non-superconductive or superconductive oxide of, for example, YBa₂Cu₃O_{7-X}. The procedure of this document further discloses elevating the temperature of YBa₂Cu₃O_{7-X} by application of laser light in a range of 500 to 800°C.

Moreover, document EP-A 0 202 895 discloses a method of manufacturing compound superconductors wherein a starting body is rapidly heated within a temperature range from 0 to 2500°C, and afterwards, the starting body is irradiated by a laser beam.

However, such conventional methods have disadvantages of difficulty in fine working, inferior working accuracy and complicated steps.

An object of the present invention is to provide a method of forming a superconducting circuit, which enables fine working of high accuracy with simple steps.

The above problem is solved by a method according to claim 1.

In the inventive method of forming a superconducting circuit, a ceramics body, which is changed from a non-superconductive phase not superconducting at its working temperature into a superconductive phase superconducting at the working temperature by heat treatment, is prepared and a laser beam is applied to the ceramics body to perform the said heat treatment by heating the exposed part of the ceramics body to a temperature of 880°C to 940°C for changing the same into the superconductive phase, thereby to form a superconducting circuit consisting of the superconductive phase and the non-superconductive phase on the ceramics body.

The present invention is based on such an empirically known phenomenon that superconductivity is effectuated or a critical temperature of superconduction is increased by performing heat treatment in the process of manufacturing a superconducting ceramics material.

When a laser beam is applied onto a part of a ceramics body which is changed from a non-superconductive phase into a superconductive phase by heat treatment, only the part exposed to the laser beam is heated to enter a superconductive phase while the rest remains in a non-superconductive phase. Thus, fine working can be performed in correspondence to the diameter of the laser beam by applying the laser beam to only a part to be provided with a superconductive phase and scanning the same, thereby to form a superconducting circuit.

Raw materials for the ceramics body may be arbitrarily prepared so far as the same contain elements which can form a superconducting substance. Preferably such raw materials are prepared by at least a single sort of element selected from those belonging to the groups Ia, IIa and IIIa of the periodic table, at least a single sort of element selected from those belonging to the groups Ib, IIb and IIIb of the periodic table and at least a single sort of element selected from oxygen, fluorine, sulfur, carbon and nitrogen.

The elements belonging to the group Ia of the periodic table are H, Li, Na, K, Rb, Cs and Fr. The elements belonging to the group IIa of the periodic table are Be, Mg, Ca, Sr, Ba and Ra. The elements belonging to the group IIIa of the periodic table are Sc, Y, La, Ce, Pr, Nd, Pm, Sm, Eu, Gd, Tb, Dy, Ho, Er, Tm, Yb, Lu, Ac, Th, Pa, U, Np, Pu, Am, Cm, Bk, Cf, Es, Fm, Md, No and Lr.

The elements belonging to the group Ib of the periodic table are Cu, Ag and Au. The elements belonging to the group IIb of the periodic table are Zn, Cd and Hg. The elements belonging to the group IIIb of the periodic table are B, Al, Ga, In and Tl.

The raw materials are preferably prepared by at least a single sort of element selected from those belonging to the group Ib of the periodic table, at least a single sort of element selected from those belonging to the group IIa, at least a single sort of element selected from those belonging to the group IIIa and oxygen.

Cu and Ag, particularly Cu is preferable in the elements belonging to the group Ib of the periodic table and Sr, Ba and Ca are preferable in the elements belonging to the group IIa, while Sc, Y and La are preferable within the elements belonging to the group IIIa.

At least one or two sorts of raw materials containing the aforementioned elements are employed in the form of powder, for example. Such powder is prepared by a compound such as an oxide, a carbo-oxide, a fluoride, a sulfide, a carbide or a nitride containing the aforementioned elements. Within such compounds, an oxide or a carbo-oxide, particularly an oxide containing oxygen is preferable. Further, the raw materials preferably contain at least copper oxide (CuO), in order to obtain a superconductive ceramics material having a high critical temperature.

A ceramics material being in composition expressed in the following general formula (1) is preferable because of a relatively high critical temperature:

AaBbCc (1)

where A represents at least a single sort of element selected from those belonging to the groups Ia, IIa and IIIa of the periodic table, B represents at least a single sort of element selected from those belonging to the groups Ib, IIb and IIIb of the periodic table and C represents at least a single sort of element selected from oxygen, fluorine, nitrogen, carbon and sulfur.

It is known that an oxide containing yttrium, barium and copper has a particularly high critical temperature.

A laser employed in the present invention is preferably prepared by that of high output, in order to improve efficiency of heat treatment. Examples of the laser are solid-state lasers such as a ruby laser, a glass laser and a YAG laser of 1.06 µm in wavelength, gas lasers such as an He-Ne laser, a Kr⁺ laser, an Ar⁺ laser, an excimer laser and a CO₂ laser of 10.6 µm in wavelength, a semiconductor laser and the like. Within these, the CO₂ laser and the YAG laser are particularly preferable. The laser beam is preferably converged through a lens to be applied onto a ceramics body, in order to increase heating efficiency. A point of application of the laser beam is preferably moved while applying the same in a focused state to the surface of the ceramics body. Alternatively, a spot of prescribed size may be formed on the surface of a substrate in a defocused state for locally heating the same, in response to width of an interconnection part of a desired superconducting circuit.

According to one of the aspects of the present invention, a ceramics body is provided on a substrate in the form of a film. Such a film is formed on the substrate by heating and vaporizing components themselves or an oxide, salt, etc. of the components while introducing oxygen, or sputtering the same.

The film thus formed on the substrate by sputtering or the like is not directly superconductive, or the same superconducts only at a temperature lower than its working temperature. The film may superconduct at the working temperature only when the same is subjected to heat treatment. The ceramics body employed in the present invention is in the state of such a film before heat treatment. A laser beam is applied to such a film to perform heat treatment, thereby to form a superconducting circuit having a superconductive phase only in a part exposed to the laser beam.

According to another aspect of the present invention, a ceramics body is prepared by a ceramics plate obtained by molding raw materials and at least preliminarily sintering the same. In other words, a substrate itself is prepared by a ceramics material of superconductive composition, in order to form a superconducting circuit on the surface of the substrate. According to this method, the surface of a substrate of ceramics, being obtained by molding superconductive ceramics raw materials and at least preliminarily sintering the same, is locally heated by a laser beam, to form an interconnection part of superconductive ceramics on the substrate.

According to such an aspect, the surface of the substrate of ceramics being obtained by molding the superconductive ceramics raw materials and at least preliminarily sintering the same is so locally heated by the laser beam as to improve heating/melting efficiency, whereby a homogeneous interconnection part of superconductive ceramics having a high critical temperature can be formed on a surface part of the locally heated substrate.

The interconnection part can be finely provided through such local heating by the laser beam, while the interconnection part of superconductive ceramics thus formed is integrated with the substrate.

In order to obtain a further homogeneous ceramics plate of a composite oxide etc. having a low melting point, it is preferable to perform a series of steps of molding a mixture of raw materials, preliminarily sintering the same and pulverizing the preliminarily sintered substance at least once thereby to obtain ceramics powder, mold the ceramics powder and at least preliminarily sinter the same to provide a ceramics plate.

The aforementioned preliminary sintering step may be performed in various atmospheres, while the same is preferably performed under presence of oxygen, e.g., in an oxygen-containing atmosphere with oxygen partial pressure of 150 to 760 mmHg, in order to obtain a homogeneous composite oxide while preventing decomposition or reduction of the raw materials. Preliminary sintering conditions such as a heating temperature and a heating time are appropriately selected in response to the raw materials as employed etc.

Even if superconductive ceramics raw materials as employed have high melting points, a composite oxide of a low melting point can be obtained through solid phase reaction in a solid phase state by performing the aforementioned series of steps at least once. Raw material of superconductive ceramics, generally having high melting points, must be sintered at a high temperature for a long time. Even if the materials are sintered under such conditions, the surface parts and the inner parts of the ceramics material are not necessarily homogeneous. However, a ceramics material being homogeneous to the interior can be obtained by performing the aforementioned series of steps at least once. In order to prepare a ceramics material composed of Y_{0.3}BaCu_{0.7}O₃ by employing Y₂O₃, BaCO₃ and CuO, for example, the raw materials, having high melting points of 1200 to 2700°C and being hard to melt, must be sintered at a high temperature for a long time. Further, ranges of the melting points of the raw materials are extremely different from each other and hence sintering conditions must be set in response to the raw material having the highest melting point. Even if sintering is performed in the said conditions, it is difficult to obtain a ceramics material of homogeneous composition. However, a composite oxide of a low melting point can be generated through the aforementioned series of steps by solid phase reaction in the aforementioned preliminary sintering step. Namely, a mixture of the raw materials is subjected to compression molding, preliminary sintering and pulverizing steps to provide a desired composite oxide having a low melting point of 900 to 1400°C, which is in a narrower melting temperature range as compared with the raw materials. Thus, the aforementioned series of steps are performed to facilitate later molding and sintering steps, as well as to obtain homogeneous ceramics powder.

The aforementioned series of steps may be performed at least once in response to the raw materials as employed and the desired composite oxide etc. Confirmation as to whether or not a desired composite oxide is generated can be made by analyzer means such as an X-ray diffractometer. Thus, the number of times for repeating the aforementioned series of steps can be set by confirming whether or not the desired composite oxide is generated by the analyzer means in response to the raw materials as employed, the sintering conditions etc. The pulverizing step may be performed through a ball mill or the like.

The ceramics powder obtained in the aforementioned manner can be easily formed by the homogeneous composite oxide of a low melting point, and sintered under a low temperature condition.

Then, the ceramics powder obtained from the aforementioned raw materials through the aforementioned series of steps is molded and at least preliminarily sintered to provide a substrate of ceramics. At least the aforementioned preliminary sintering step may be performed in order to obtain an integrated substrate, while essential firing may be performed to further improve integrality of the substrate. The substrate obtained in the aforementioned manner may have a low critical temperature, since the same is provided with a superconducting circuit by an interconnection part of superconductive ceramics having a high critical temperature by application of a laser beam. The substrate obtained by the aforementioned ceramics powder of a homogeneous composite oxide is superconductive and has a high critical temperature. The critical temperature of the substrate can be controlled by adjusting the number of times for repeating the aforementioned series of steps. In the aforementioned molding step, the material can be shaped into an appropriate configuration of a block, a sheet or the like while preliminary and essential sintering conditions are appropriately selected in response to the melting points of the raw materials and the aforementioned ceramics powder and desired characteristics of the substrate.

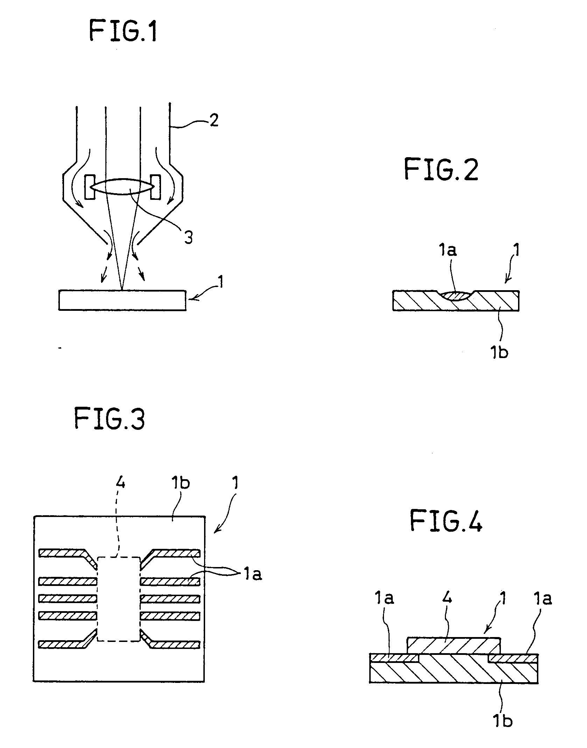

In order to form a superconductive phase on the surface of a ceramics plate serving as the aforementioned substrate, the surface of the ceramics plate is preferably locally heated by a laser beam under presence of oxygen. In more concrete terms, a laser beam is passed through a cylindrical body 2 as shown in Fig. 1 and converged into a focused state by a lens 3 held in the cylindrical body 2 to be applied to the surface of a substrate 1 for heating/melting operation. The point of application of the laser beam is moved to form a prescribed interconnection part having a higher critical temperature of superconduction than the substrate 1. In order to supply oxygen to the surface of the substrate 1, oxygen gas or mixed gas having high oxygen partial pressure is fed to the cylindrical body 2, to be sprayed to the surface of the substrate 1 from a forward end portion of the cylindrical body 2. While the aforementioned heating/melting operation by the laser beam may be performed under various atmospheres, such operation may be performed under presence of oxygen in order to form a superconducting circuit having a high critical temperature on the surface of the substrate 1 while preventing reduction or decomposition of an oxide etc. forming the ceramics material. The laser beam is preferably applied to the surface of the substrate 1 while supplying oxygen to the substrate surface by a method of spraying oxygen gas or mixed gas having high oxygen partial pressure of 150 to 760 mmHg, for example.

Through such operation, a superconductive ceramics material having a higher critical temperature than a substrate part 1b is generated in a part heated/molten by the laser beam, thereby to form a superconducting circuit consisting of the substrate part 1b and an interconnection part 1a of superconductive ceramics which has a higher critical temperature than the substrate part 1b, as shown in Figs. 2 and 3. Further, a low-temperature operating device 4 such as SQUID (superconducting quantum interference device) or GaAs HEMT (high electron mobility transistor) can be placed on an interconnection part 1a of a substrate 1 as shown in Fig. 4, to serve as an element through the interconnection part 1a of superconductive ceramics. Thus, according to this aspect, a ceramics body is prepared by a ceramics plate obtained by molding raw materials and at least preliminarily sintering the same to serve as a substrate, thereby to form a superconducting circuit by applying a laser beam on the surface of the substrate. Thus, a substrate integrated with a superconducting circuit can be obtained so that the substrate and the superconducting circuit may not be separately prepared, whereby manufacturing steps can be simplified.

According to the inventive method, a superconducting circuit can be finely worked in further accuracy as compared with the conventional method, through a simple process of applying a laser beam.

Further, depth of a superconductive phase can be adjusted by changing energy of the laser beam. The inventive method is effectively applied to manufacturing of a switching element, a memory element, a magnetic flux sensor, an amplifier element, a thin motor etc., which are employed in various fields such as those of electronics and power application.

In the aforementioned first aspect of the present invention, a ceramics body to be provided with a superconducting circuit is a film formed on a substrate. According to this aspect, the circuit can be simply formed as compared with a conventional method of forming a circuit by performing ion sputtering and partially scraping off a thin film, while an interconnection part of the circuit can be finely worked in width.

According to the aforementioned another aspect of the present invention, a ceramics body to be provided with a superconducting circuit is prepared by a ceramics plate, also serving as a substrate, obtained by molding raw materials and at least preliminarily sintering the same. According to this aspect, the superconducting circuit can be integrally formed on the surface of the substrate so that the same may not be prepared separately from the substrate, whereby manufacturing steps can be simplified.

These and other objects, features, aspects and advantages of the present invention will become more apparent from the following detailed description of the present invention when taken in conjunction with the accompanying drawings.
Fig. 1 schematically illustrates an exemplary step of performing heat treatment by a laser beam in a method according to the present invention;
Fig. 2 is a schematic sectional view showing a ceramics body which is formed with a superconducting circuit according to a first embodiment of the present invention;
Fig. 3 is a plan view schematically showing a ceramics body which is formed with a superconducting circuit according to a second embodiment of the present invention;
Fig. 4 is a sectional view schematically showing an example of a device employing a ceramics body formed with a superconducting circuit according to a third embodiment of the present invention;
Fig. 5 illustrates the result of a fourth embodiment (Example 1) of the present invention;
Fig. 6 is a perspective view showing a state during scanning of a laser beam in a fifth embodiment (Example 2) of the present invention;
Fig. 7 is a perspective view showing a state after application of the laser beam in the fifth embodiment (Example 2) of the present invention;
Fig. 8 is a perspective view showing a state for measuring temperature-resistance characteristics of a part exposed to a laser beam;
Fig. 9 is a perspective view showing a state of measuring temperature-resistance characteristics in case of connecting one of four terminals to a part not exposed to the laser beam;
Fig. 10 is a perspective view for illustrating a sixth embodiment (Example 3) of the present invention;
Fig. 11 illustrates current-voltage characteristics of a bridge type Josephson junction device obtained by the sixth embodiment (Example 3) of the present invention; and
Fig. 12 is a perspective view showing a seventh embodiment (Example 4) of the present invention.

Description is now made on an embodiment employing a ceramics body formed by a ceramics plate which is obtained by molding raw materials and at least preliminarily sintering the same.

### Example 1

Prescribed amounts of powder materials of Y₂O₃, BaCO₃ and CuO, being raw materials for a ceramics body, were weighed and mixed with each other. Such mixed powder was compression-molded into a sheet at the normal temperature in the atmospheric air of 100 atm., and preliminarily sintered in a mixed gas atmosphere of oxygen gas and nitrogen gas with oxygen gas partial pressure of 200 mmHg at 940°C for 24 hours. A preliminarily sintered ceramics body thus obtained was pulverized by a ball mill. Such series of steps were repeated until a composite oxide of Y_{0.3}BaCu_{0.7}O₃ was confirmed by X-ray diffraction.

Ceramics powder of the composite oxide obtained in the aforementioned manner was compression-molded into a sheet and sintered in the atmospheric air at 800°C for two hours, to prepare a substrate. A beam of 1 to 10 W from a CO₂ laser was converged to about 0.1 mm in diameter to locally heat/melt the surface of the substrate while spraying oxygen gas onto the substrate surface. Such a local heating point was moved to form a prescribed interconnection part. Finally heat treatment was performed under an oxygen atmosphere in a heat treating furnace at 700°C for five hours.

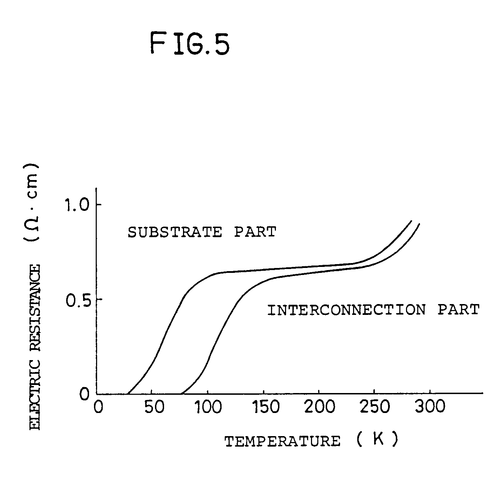

As the result of measurement of critical temperatures based on electric resistance, the interconnection part heated/molten by the laser beam superconducted at a temperature of not more than 80 K while the substrate part superconducted at a temperature of not more than 30 K, as shown in Fig. 5. Thus, it has been recognized that the substrate part relatively entered a non-superconductive phase and the interconnection part of a superconducting circuit entered a superconductive phase by cooling the substrate in a temperature range of 30 to 80 K.

Description is now made on an embodiment employing a ceramics body prepared by a film formed on a substrate.

### Example 2

A film composed of YBa_{1.8}Cu_{2.7}Oₓ having (100) surface of strontium titanate of 15 x 15 mm in size as a substrate surface was formed in thickness of 0.5 µm by magnetron high-frequency sputtering. An atmosphere gas was prepared by argon-oxygen mixed gas containing 10 % of oxygen, with pressure of 1 x 10⁻² torr. and a substrate temperature of 600°C. A film thus formed was not directly superconductive.

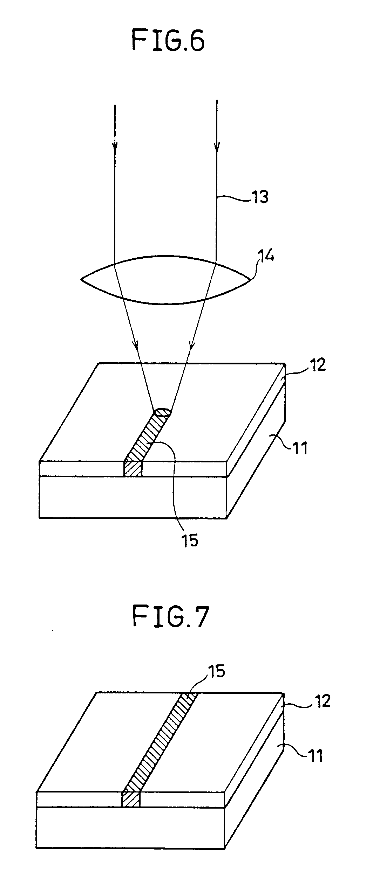

A laser beam was applied onto the film as shown in Fig. 6. Referring to Fig. 6, numeral 11 indicates the substrate, numeral 12 indicates the film, numeral 13 indicates the laser beam, numeral 14 indicates a lens of zinc selenide (ZnSe), and numeral 15 indicates a part exposed to the laser beam in hatching. It is to be noted that, in Fig. 6, the film 12 is shown in an enlarged manner as compared with actual size. The laser beam 13 was emitted from a CO₂ laser in wavelength of 10.6 µm with power of 20 W/cm² and a scanning rate of 0.01 mm/sec. The ZnSe lens 14 was adapted to converge the laser beam 13 to be in a spot diameter of 1 mm.

A platinum-platinum rhodium thermocouple was placed in the vicinity of the exposed part 15 to measure the temperature thereof, which was 880 to 940°C.

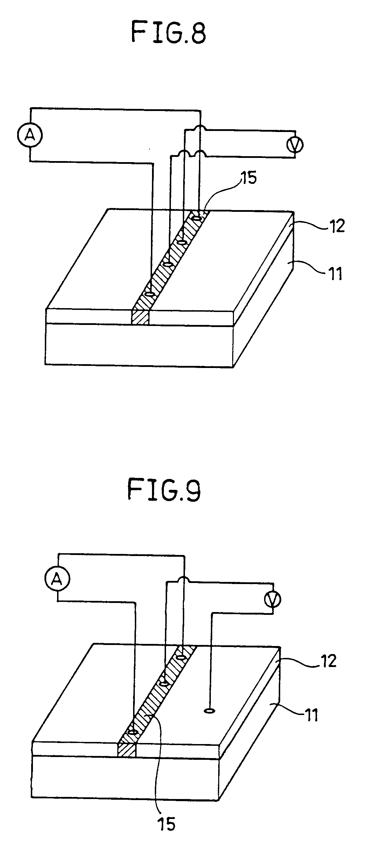

An exposed part 15 as shown in Fig. 7 was formed on the film 12 by the aforementioned scanning of the laser beam 13. As shown in Fig. 8, copper wires were interconnected to the exposed part 15 to measure temperature-resistance characteristics. The so-called critical temperature showing 10⁻⁷ Ω, the limit of the measuring apparatus, was 78 K.

When one of four terminals was interconnected to a part not exposed to the laser beam as shown in Fig. 9, no superconductivity was recognized even at the temperature of liquid helium (4 K).

Thus, it has been confirmed that only the exposed part 15 was in a superconductive phase. Referring to Figs. 6 to 9, identical reference numerals indicate the same components.

The laser beam 13 was applied in an oxygen atmosphere in this Example. Such an oxygen atmosphere may be implemented by a method of introducing an appropriate amount of oxygen into a vessel, or a method of spraying oxygen to the exposed part 13. It is not necessarily required in the present invention to apply the laser beam under an oxygen atmosphere, while oxygen may be taken into composition of the film through application of the laser beam in an oxygen atmosphere, to improve superconductivity.

A film prepared under the conditions of this Example was subjected to heat treatment with a substrate under presence of oxygen at 900°C for two hours without exposure to a laser beam, whereby the so-called critical temperature, at which electric resistance substantially reached zero, was 84 K.

### Example 3

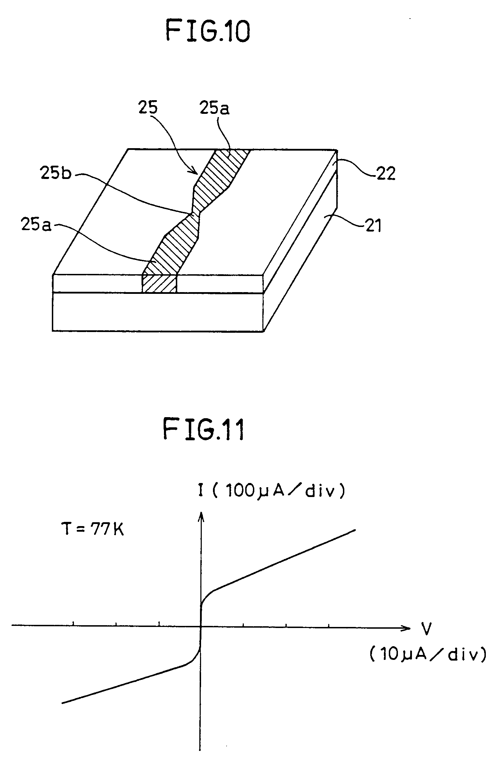

As shown in Fig. 10, a film 22 was formed on a substrate 21 in a similar manner to Example 2, and an exposed part 25 was formed in the film 22 by application of a laser beam. Wide portions 25a of the exposed part 25 were formed by scanning of the laser beam in a spot diameter of 1 mm at a scanning rate of 1 mm/sec. A narrow junction portion 25b was formed by scanning of the laser beam with a spot diameter of 10 µm at a scanning rate of 10 mm/sec. Finally heat treatment was performed under an oxygen atmosphere in a furnace at 800°C for two hours.

Copper wires were interconnected to the wide portions 25a on both sides of the junction portion 25b respectively, to measure current-voltage characteristics at 77 K. Fig. 11 shows the result. As obvious from Fig. 11, it has been confirmed that the junction portion 25b of the exposed part 25 served as a bridge type Josephson device.

### Example 4

Description is now made on the case of employing lanthanum as an element belonging to the group IIIa of the periodic table, strontium as an element belonging to the group IIa of the periodic table and copper as an element belonging to the group Ib of the periodic table. A ceramics substrate 32 was set in a vacuum chamber to be heated to about 100 to 1000°C. Then, crucibles containing lanthanum, strontium and copper were heated to 100 to 1000°C respectively. After vapor pressures of the respective elements were thus obtained to some extent, oxygen was introduced from a nozzle 35 provided in the vicinity of the substrate 32 and finally shutteres provided in upper portions of vaporization sources of the respective elements were opened, thereby to perform vapor deposition on the substrate 32.

Such a substrate 32 can be prepared by a ceramics plate of Al₂O₃, BN or the like.

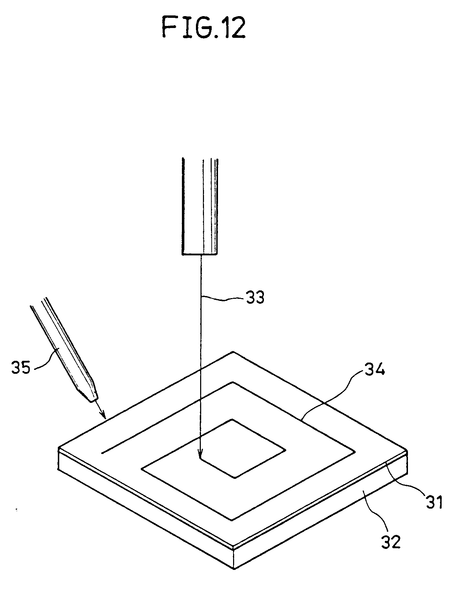

Thereafter a thin film 31 thus formed was exposed to a laser beam 33, which was restricted in beam diameter, in the air or with spraying of oxygen as shown in Fig. 12. Thus, a part of the thin film 31 exposed to the laser beam 33 was heated to about 1000°C to be sintered, thereby to provide a superconductive phase 34 being in superconductive crystal structure.

Thus, the superconductive phase 34 could be formed by scanning of the laser beam 33.

## Claims

1. A method of forming a superconducting circuit comprising the steps of:
Preparing a cermics body being changed from a non-superconductive phase not superconducting at its working temperature into a superconductive phase superconducting at the working temperature by heat treatment; and
performing said heat treatment on a part of said ceramics body by applying a laser beam to said ceramics body, said laser beam heating the exposed part of said ceramics body to a temperature of 880°C to 940°C, to change the same into said superconductive phase thereby forming a superconducting circuit consisting of said superconductive phase and said non-superconductive phase on said ceramics body.

2. A method of forming a superconducting circuit in accordance with claim 1, wherein
said ceramics body is a film formed on a substrate.

3. A method of forming a superconducting circuit in accordance with claim 1, wherein
said ceramics body is a ceramics plate obtained by molding raw materials and at least preliminarily sintering the same.

4. A method of forming a superconducting circuit in accordance with claim 3, wherein
said ceramics plate is prepared by performing a series of steps of molding, preliminary molding and pulverization of a preliminarily sintered substance at least once after mixing of said raw materials to obtain ceramics powder, molding said ceramics powder and at least preliminarily sintering the same.

5. A method of forming a superconducting circuit in accordance with claim 1, wherein
said heat treatment by application of said laser beam is performed under presence of oxygen.

6. A method of forming a superconducting circuit in accordance with claim 5, wherein
said heat treatment by application of said laser beam is performed while supplying oxygen to the surface of said ceramics body.

7. A method of forming a superconducting circuit in accordance with claim 1, wherein
said laser beam is emitted from a CO₂ laser or a YAG laser.

8. A method of forming a superconducting circuit in accordance with claim 1, wherein
said raw materials for said ceramics body contain at least a single sort of element selected from those belonging to the groups Ia, IIa and IIIa of the periodic table, at least a single sort of element selected from those belonging to the groups Ib, IIb and IIIb of the periodic table and at least a single sort of element selected from oxygen, fluorine, sulfur, carbon and nitrogen.

9. A method of forming a superconducting circuit in accordance with claim 8, wherein
said raw materials for said ceramics body contain at least copper oxide.

10. A method of forming a superconducting circuit in accordance with claim 9, wherein
said ceramics body is prepared by an oxide containing yttrium, barium and copper.

## Patentansprüche

1. Verfahren zur Herstellung einer supraleitenden Schaltung, das die Schritte umfaßt:
Anfertigen eines Keramikkörpers, der durch Hitzebehandlung aus einer nicht-supraleitenden Phase, die bei ihrer Betriebstemperatur nicht supraleitet, in eine supraleitende Phase überführt wird, die bei Betriebstemperatur supraleitet; und
Durchführen der Hitzebehandlung auf einem Teil des Keramikkörpers durch Anwendung eines Laserstrahls an dem Keramikkörper, wobei der Laserstrahl den exponierten Teil des Keramikkörpers auf eine Temperatur von 880 °C bis 940 °C erhitzt, um denselben in die supraleitende Phase zu überführen, und dadurch eine supraleitende Schaltung erzeugt, die aus der supraleitenden Phase und der nicht-supraleitenden Phase auf dem Keramikkörper besteht.

2. Verfahren zur Herstellung einer supraleitenden Schaltung nach Anspruch 1, wobei der Keramikkörper ein auf einem Substrat erzeugter Belag ist.

3. Verfahren zur Herstellung einer supraleitenden Schaltung nach Anspruch 1, wobei der Keramikkörper eine Keramikplatte ist, die durch Formen von Rohmaterialien und mindestens Vorsintern derselben erhalten wird.

4. Verfahren zur Herstellung einer supraleitenden Schaltung nach Anspruch 3, wobei die Keramikplatte durch Ausführen einer Reihe von Schritten angefertigt wird, nämlich:
Formen,
Vorformen und mindestens einmaliges Pulverisieren einer vorgesinterten Substanz nach Mischen des Rohmaterials zur Gewinnung von Keramikpulver,
Formen des Keramikpulvers und
zumindest Vorsintern desselben.

5. Verfahren zur Herstellung einer supraleitenden Schaltung nach Anspruch 1, wobei die Hitzebehandlung durch Anwenden des Laserstrahls in Gegenwart von Sauerstoff durchgeführt wird.

6. Verfahren zur Herstellung einer supraleitenden Schaltung nach Anspruch 5, wobei die Hitzebehandlung durch Anwenden des Laserstrahls bei Versorgung der Oberfläche des Keramikkörpers mit Sauerstoff durchgeführt wird.

7. Verfahren zur Herstellung einer supraleitenden Schaltung nach Anspruch 1, wobei der Laserstrahl von einem CO₂-Laser oder YAG-Laser ausgesandt wird.

8. Verfahren zur Herstellung einer supraleitenden Schaltung nach Anspruch 1, wobei die Rohmaterialien für den Keramikkörper enthalten:
mindestens eine einzelne Element-Art, ausgewählt aus jenen, die zu den Gruppen Ia, IIa und IIIa des Periodensystems gehören,
mindestens eine einzelne Element-Art, ausgewählt aus jenen, die zu den Gruppen Ib, IIb und IIIb des Periodensystems gehören, und
mindestens eine einzelne Element-Art, ausgewählt aus Sauerstoff, Fluor, Schwefel, Kohlenstoff und Stickstoff.

9. Verfahren zur Herstellung einer supraleitenden Schaltung nach Anspruch 8, wobei die Rohmaterialien für den Keramikkörper mindestens Kupferoxid enthalten.

10. Verfahren zur Herstellung einer supraleitenden Schaltung nach Anspruch 9, wobei der Keramikkörper aus einem Oxid hergestellt ist, das Yttrium, Barium und Kupfer enthält.

## Revendications

1. Procédé pour former un circuit supra-conducteur comprenant les étapes consistant à :
préparer un corps de céramique qui est changé à partir d'une phase non supra-conductrice, non supra-conductrice à sa température de travail, en une phase supra-conductrice, supra-conductrice à la température de travail, par traitement thermique, et
effectuer ledit traitement thermique sur une partie dudit corps de céramique en appliquant un faisceau laser sur ledit corps de céramique, ledit faisceau laser chauffant la partie exposée dudit corps de céramique à une température située entre 880°C et 940°C, pour passer celui-ci à ladite phase supra-conductrice, formant de ce fait un circuit supra-conducteur qui est constitué de ladite phase supraconductrice et de ladite phase non supra-conductrice sur ledit corps de céramique.

2. Procédé pour former un circuit supra-conducteur selon la revendication 1, dans lequel
ledit corps de céramique est un film formé sur un substrat.

3. Procédé pour former un circuit supra-conducteur selon la revendication 1, dans lequel
ledit corps de céramique est une plaque de céramique obtenue par moulage de matériaux bruts et par frittage de manière au moins préliminaire de ceux-ci.

4. Procédé pour former un circuit supra-conducteur selon la revendication 3, dans lequel
ladite plaque de céramique est préparée en effectuant une série d'étapes de moulage, de moulage et de pulvérisation préliminaires d'une substance préliminairement frittée au moins une fois après le mélange desdits matériaux bruts afin d'obtenir une poudre de céramique, de moulage de ladite poudre de céramique et du frittage de manière au moins préliminaire de celle-ci.

5. Procédé pour former un circuit supra-conducteur selon la revendication 1, dans lequel
ledit traitement thermique par application dudit faisceau laser est effectué en présence d'oxygène.

6. Procédé pour former un circuit supra-conducteur selon la revendication 5, dans lequel
ledit traitement thermique par application dudit faisceau laser est effectué tout en délivrant de l'oxygène à la surface dudit corps de céramique.

7. Procédé pour former un circuit supra-conducteur selon la revendication 1, dans lequel
ledit faisceau laser est émis à partir d'un laser CO₂ ou d'un laser YAG.

8. Procédé pour former un circuit supra-conducteur selon la revendication 1, dans lequel
lesdits matériaux bruts pour ledit corps de céramique contiennent au moins un seul choix d'éléments sélectionnés parmi ceux appartenant au groupe Ia, IIa et IIIa du tableau périodique, au moins un seul type d'éléments sélectionnés parmi ceux appartenant au groupe Ib, IIb et IIIb du tableau périodique et au moins un seul type d'élément sélectionné à partir de l'oxygène, du fluor, du soufre, du carbone et de l'azote.

9. Procédé pour former un circuit supra-conducteur selon la revendication 8, dans lequel
lesdits matériaux bruts pour ledit corps de céramique contiennent au moins de l'oxyde de cuivre.

10. Procédé pour former un circuit supra-conducteur selon la revendication 9, dans lequel
ledit corps de céramique est préparé par un oxyde contenant de l'yttrium, du baryum et du cuivre.
